(19) Europäisches Patentamt
European Patent Office
Office européen des brevets

(11) **EP 2 622 615 B1**

(12) **EUROPÄISCHE PATENTSCHRIFT**

(45) Veröffentlichungstag und Bekanntmachung des Hinweises auf die Patenterteilung:
**13.08.2014 Patentblatt 2014/33**

(21) Anmeldenummer: **10765774.4**

(22) Anmeldetag: **29.09.2010**

(51) Int Cl.:
*H01F 27/34* *(2006.01)*        *H03H 7/01* *(2006.01)*
*H01F 27/42* *(2006.01)*

(86) Internationale Anmeldenummer:
**PCT/EP2010/064393**

(87) Internationale Veröffentlichungsnummer:
**WO 2012/041367 (05.04.2012 Gazette 2012/14)**

(54) **ANORDNUNG UND VERFAHREN ZUR KOMPENSATION EINES MAGNETISCHEN GLEICHFLUSSES IN EINEM TRANSFORMATORKERN**

ARRANGEMENT AND METHOD FOR THE COMPENSATION OF A MAGNETIC UNIDIRECTIONAL FLUX IN A TRANSFORMER CORE

DISPOSITIF ET PROCÉDÉ POUR COMPENSER UN FLUX MAGNÉTIQUE CONTINU DANS UN NOYAU DE TRANSFORMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**07.08.2013 Patentblatt 2013/32**

(73) Patentinhaber: **Siemens Aktiengesellschaft**
**80333 München (DE)**

(72) Erfinder:
• **HAMBERGER, Peter**
**A-4202 Kirchschlag bei Linz (AT)**

• **LEIKERMOSER, Albert**
**A-5020 Salzburg (AT)**

(74) Vertreter: **Maier, Daniel Oliver et al**
**Siemens AG**
**Postfach 22 16 34**
**80506 München (DE)**

(56) Entgegenhaltungen:
WO-A1-2008/151661      DE-A1- 10 241 249
DE-C- 634 027          GB-A- 2 224 407
JP-A- 2 063 310        JP-A- 2002 204 137
US-A- 2 730 667        US-A1- 2006 049 890

**Beschreibung**

Technisches Gebiet

Die Erfindung betrifft eine Anordnung und ein Verfahren zur Kompensation eines magnetischen Gleichflusses in einem Transformatorkern, mit einem Gleichstromerzeuger zum Einspeisen eines Kompensationsstroms in eine mit dem Transformatorkern magnetisch gekoppelte Kompensationswicklung.

Stand der Technik

Elektrische Transformatoren wie sie typischerweise heutzutage in einem Energieverteilungsnetz verwendet werden, werden zunehmend mit einer Stromkomponente beaufschlagt, welche bezüglich des Energie-Verteilungsnetzes als Gleichstrom-Komponente anzusehen sind. Diese Gleichstrom-Komponente, im Folgenden auch als "DC-Anteil" bezeichnet, kann beispielsweise aus dem verstärkten Einsatzes von leistungselektronischen Bauteilen im Netz herrühren, wie sie üblicherweise für die Ansteuerung elektrischer Antriebe oder zur Blindleistungskompensation verwendet werden. Ein "DC-Anteil" kann aber auch durch sogenannte "Geomagnetically Induced Currents" (GIC) verursacht werden. Folge eines "DC-Anteils" ist ein magnetischer Gleichfluss-Anteil im Kern. Es kommt zu einer Verschiebung bei der magnetischen Aussteuerung, das heißt je nach Halbperiode erfolgt die Aussteuerung einmal etwas mehr, dann wieder etwas weniger stark. Da man heute grundsätzlich bestrebt ist, den magnetischen Kernwerkstoffs möglichst mit einer hohen Ausnutzung zu betreiben, ist der Transformator heutiger Bauart bezüglich eines "DC-Anteils" besonders empfindlich. Obwohl in der Praxis der Gleichstrom häufig nur einige Promille des Transformator-Nennstroms ausmacht, führt er zu einer Reihe von störenden Effekten. Da der Magnetisierungsstrom nicht mehr sinusförmig ist, sondern verzerrt ist, kommt es zu lokalen Erwärmungen im Transformatorkern und in der elektrischen Wicklung. Lokale Erwärmungen, so genannte "hot spots" können die Isolationseigenschaften der elektrischen Wicklung beeinträchtigen. Aufgrund der stärkeren Magnetostriktion erhöht sich außerdem die Geräuschemission bei Betrieb des Transformators. Eine erhöhte Geräuschentwicklung ist aber insbesondere dann von Nachteil, wenn der Transformator in der Nähe eines Wohnbereichs installiert werden soll. Es besteht daher der Wunsch, den magnetischen Gleichfluss-Anteil im Transformatorkern möglichst gering zu halten.

Eine Möglichkeit den störenden Gleichfluss-Anteil zu reduzieren besteht darin, am Transformatorkern eine Kompensationswicklung anzuordnen, in welche mittels einer steuerbaren Gleichstromquelle ein Kompensationsstrom eingespeist wird, der dem Gleichfluss-Anteil entgegen gerichtet ist. Dabei tritt das Problem auf, dass in der Kompensationswicklung eine elektrische Spannung in einer Größenordnung induziert wird, welche für die einspeisende Gleichstromquelle eine sehr hohe Spannungsbürde bedeutet.

In der WO 2008/151661 wird daher vorgeschlagen, die Kopplung zwischen der Gleichstromquelle und der Kompensationswicklung über einen Sperrkreis, einen so genannten Reaktanzzweipol herzustellen. In seiner einfachsten Ausprägung besteht dieser Reaktanzzweipol aus einer Parallelschaltung eines Kondensators und einer Induktivität. Da am Reaktanzzweipol nahezu die gesamte induzierte Spannung abfällt, muss der Kondensator für diese hohe Spannung ausgelegt sein. Bei Transformatoren mit hoher Leistung, das heißt hoher Betriebsspannung, ergeben sich daraus sehr hohe technische Anforderungen an den Kondensator. Kondensatoren die diese Anforderungen erfüllen sind nicht nur sehr kostspielig, sondern auch sehr voluminös. Die hohe Betriebsspannung beeinträchtig auch die Zuverlässigkeit des Kondensators und damit die des Reaktanzzweipols.

Aus DE634027C ist bekannt, dass ungünstige Kapazitätswerte durch eine transformatorische Ankopplung von Kondensatoren mit einer geeigneten Wahl des Übersetzungsverhältnisses vermieden werden können, so dass sich Kondensatoren beispielsweise kleiner ausführen lassen.

Darstellung der Erfindung

Es ist eine Aufgabe der vorliegenden Erfindung eine Anordnung und ein Verfahren so anzugeben, dass mit einem möglichst geringen technischen Aufwand und mit hoher Zuverlässigkeit eine Einspeisung eines Kompensationsstroms in eine Kompensationswicklung eines Transformators möglich ist.

Diese Aufgabe wird durch eine Anordnung mit den Merkmalen des Patentanspruchs 1 und für ein Verfahren mit den Merkmalen des Anspruchs 5 gelöst. Vorteilhafte Ausgestaltungen der Erfindung sind in den abhängigen Ansprüchen definiert.

Erfindungsgemäß wird bei der Einspeisung eines Kompensationsstroms in die Kompensationswicklung eines Transformators ein Reaktanzzweipol verwendet, bei dem im Parallelzweig des Kondensators die Spannung herabgesetzt ist. Diese Herabsetzung der Spannung wird dadurch erreicht, indem die Induktivität nach Art eines Koppeltransformators ausgebildet ist und zwei Wicklungen aufweist: Eine erste Wicklung ist zum Zweck der Einspeisung mit ihrem einen Ende mit den Gleichstromerzeuger und mit ihrem anderen Ende mit der Kompensationswicklung verbunden. Eine zweite Wicklung bildet mit dem Kondensator eine Parallelschaltung. Durch entsprechende Wahl der Windungszahl der ersten und zweiten Wicklung lässt sich die Spannungsbelastung des Kondensators herabsetzen. Die Herabsetzung der Spannung für den Reaktanzzweipol-Kondensator kann auf einfache Weise dadurch erreicht werden, indem das Verhältnis, gebildet aus der Windungszahl $N_2$ der zweiten Wicklung und der Windungszahl $N_1$ der ersten Wicklung gemäß der Beziehung $N_2/N_1 < 1$ ausgeführt wird. Die Spannung am Kondensator kann dadurch frei wählbar verringert werden. Bei der Auslegung des Sperrkreises (Resonanzbedingung des Parallelkreises) kann die verringerte Spannung durch entsprechende Wahl der Kapazität leicht ausgeglichen werden: Verglichen mit einem Reaktanzzweipol der nur aus einer Wicklung besteht, muss der Kondensator eine um $(N_1/N_2)^2$ höhere Kapazität haben. Der Reaktanzzweipol weist daher eine bessere technische Zuverlässigkeit auf und ist kostengünstiger in der Herstellung. Ein zusätzlicher Koppeltransformator ist nicht erforderlich.

Da wie gesagt über die erste Wicklung der Kompensationsstrom fließt, muss der Wert dieser Induktivität im Wesentlichen konstant bleiben, das heißt, sie ist so auszuführen, dass möglichst keine Sättigungserscheinungen auftreten. Daher ist der magnetische Kern, der die erste mit der zweiten Wicklung koppelt, mit einem Luftspalt versehen.

Damit die in der Kompensationswicklung induzierte Spannung nahezu vollständig über den Reaktanzzweipol abfällt, sollte der Reaktanzzweipol für alle Frequenzen entsprechend einem ungeradzahligen ganzzahligen Vielfachen der Netzfrequenz eine möglichst hohe Impedanz aufweisen. Nun ist es aber so, dass der Reaktanzzweipol für die Grundschwingung die größte Impedanz aufweist, je stärker die induktive Kopplung zwischen der ersten und der zweiten Wicklung ist. Für die Oberschwingung ist es jedoch gerade umgekehrt, die vorteilhafte Impedanz für die Oberschwingungen ist dann gegeben, wenn die Kopplung zwischen der ersten und der zweiten Wicklung möglichst klein ist. Ein für die Praxis günstiger Kompromiss dieser beiden gegensätzlichen Anforderungen ist dann gegeben, wenn der Grad der Kopplung $\varepsilon$ zwischen der ersten Wicklung und der zweiten Wicklung durch die Beziehung

$$\varepsilon \neq [(n^2-1)/n^2] \text{ für alle } \varepsilon\{3,5,7,9,...\}$$

gebildet ist.

Kurzbeschreibung der Zeichnungen

Zur weiteren Erläuterung der Erfindung wird im nachfolgenden Teil der Beschreibung auf die Zeichnung Bezug genommen, aus der weitere vorteilhafte Ausgestaltungen, Wirkungen und Vorteile der Erfindung hervorgehen.
Es zeigen:

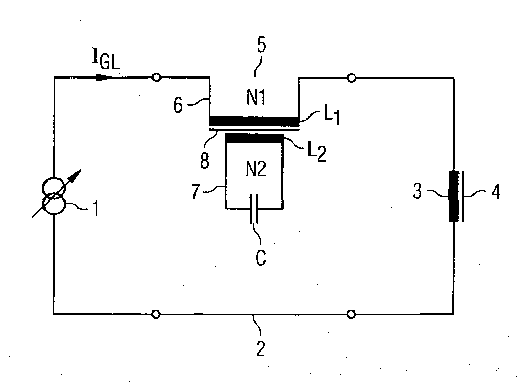

Figur 1    einen erfindungsgemäßen Reaktanzzweipol, ausgebildet als Parallelschwingkreis, wobei die Induktivität aus einer ersten und einer zweiten Wicklung gebildet ist.

Ausführung der Erfindung

Die Figur 1 zeigt eine mit dem Kern 4 eines nicht näher dargestellten Transformators magnetisch gekoppelte Kompensationswicklung 3. Zum Zwecke der Verringerung oder Auslöschung eines im Kern 4 des Transformators fließenden Gleichfluss-Anteils, soll in die Kompensationswicklung 3 ein entsprechender Kompensationsstrom eingespeist werden. Üblicherweise besteht die Kompensationswicklung nur aus einer Wicklung mit wenigen Windungen.
Der Kompensationsstrom ist ein Gleichstrom und wird von einem Gleichstromerzeuger 1 erzeugt. Dieser Gleichstromerzeuger 1 kann aus einer gesteuerten Halbleiter-Schaltvorrichtung bestehen. Der Gleichstromerzeuger 1 ist über einen Stromkreis 2 mit der Kompensationswicklung 3 verbunden. Eine nicht näher dargestellte Mess- und Steuereinrichtung gibt das maß des eingespeisten Kompensationsstroms $I_{GL}$ vor.
Um die Spannungsbürde für den Gleichstromerzeuger 1 möglichst gering zu halten, befindet sich im Stromkreis 2 ein Reaktanzzweipol 5, der erfindungsgemäß wie folgt ausgebildet ist:.
Der Reaktanzzweipol 5 besteht aus einer Parallelschaltung einer Kapazität C mit einer erfindungsgemäß aus zwei Wicklungen 6 und 7 (Induktivitäten L1 und L2) gebildeten Induktivität. Die erste Wicklung 6 (Induktivitäten L1) liegt im Stromkreis 2 in Serie zum Gleichstromerzeuger 1 und der Kompensationswicklung 3. Die zweite Wicklung 7 (Induktivitäten L2) liegt außerhalb des Strompfads 2 und ist mit einem Kondensator C parallel geschaltet. Die am Kondensator C anliegende Spannung ist durch ein geeignetes Verhältnis der Windungszahlen N1 und N2 herabgesetzt. Damit kann ein kostengünstiger Kondensator gewählt werden.
Zweckmäßig ist eine Anordnung, bei der nur die Kompensationswicklung im Transformatorkessel angeordnet und die anderen Baukomponenten außerhalb.

Im Ergebnis ist die Spannungsbürde des Gleichstromerzeugers 1 mit einer einfachen und zuverlässig wirkenden Schaltungsvorrichtung herabgesetzt, so dass diese kostengünstig ausgeführt werden kann.

Zusammenstellung der verwendeten Bezugszeichen

1   Gleichstromerzeuger
2   Strompfad
3   Kompensationswicklung
4   Kern des Transformators
5   Reaktanzzweipol
6   erste Wicklung
7   zweite Wicklung
8   weichmagnetischer Kern der Induktivität des Reaktanzzweipols

$I_{GL}$   Kompensationsstrom

**Patentansprüche**

**1.**   Anordnung zum Verringern eines Gleichfeldanteils im Kern eines Transformators, umfassend:

- eine Kompensationswicklung (3), die mit dem Kern (4) des Transformators magnetisch gekoppelt ist,
- einen Gleichstromerzeuger (1), der in Reihe mit der Kompensationswicklung (3) und mit einem Reaktanzzweipol (5) angeordnet ist, wobei der Reaktanzzweipol (5) aus einer Parallelschaltung einer Induktivität und einem Kondensator gebildet ist, um in die Kompensationswicklung (3) einen Kompensationsstrom ($I_{GL}$) einzuspeisen, dessen Wirkung dem Gleichfeldanteil im Kern (4) entgegengesetzt gerichtet ist,

**dadurch gekennzeichnet,**

- **dass** die Induktivität aus einer ersten Wicklung (6) gebildet ist, welche mit einer zweiten Wicklung (7) magnetisch gekoppelt ist, wobei das Verhältnis gebildet aus der Windungszahl $N_2$ der zweiten Wicklung (7) und der Windungszahl $N_1$ der ersten Wicklung (6) gemäß der Beziehung $N_2/N_1 < 1$ gebildet ist,
- **dass** die erste Wicklung (6) mit ihrem einen Ende mit dem Gleichstromerzeuger (1) und mit ihrem anderen Ende mit der Kompensationswicklung (3) verbunden ist, und
- **dass** die zweite Wicklung (7) mit dem Kondensator (C) parallel geschaltet ist, und
- **dass** die magnetische Kopplung der ersten Wicklung (6)und der zweiten Wicklung (7) mittels eines weichmagnetischen Kerns (8) hergestellt ist, der einen Luftspalt aufweist.

**2.**   Einrichtung nach einem der Ansprüche 1, **dadurch gekennzeichnet, dass** der Grad der Kopplung $\varepsilon$ zwischen der ersten Wicklung (6) und der zweiten Wicklung (7) durch die Beziehung

$$\varepsilon \neq [(n^2-1)/n^2] \text{ für alle } n\{3,5,7,9,...\}$$

gebildet ist.

**3.**   Verfahren zum Verringern eines Gleichfeldanteils im Kern eines Transformators, wobei ein Gleichstromerzeuger(1) in eine mit dem Kern (4) des Transformators gekoppelte Kompensationswicklung (3) einen Kompensationsstrom ($I_{GL}$) einspeist, der in seiner Wirkung dem Gleichfeldanteil entgegengesetzt gerichtet ist, wobei der Kompensationsstrom ($I_{GL}$) in einen Stromkreis (2) mit einem Reaktanzzweipol (5) geführt wird, wobei der Reaktanzzweipol (5) eine Induktivität und eine Kapazität aufweist, **dadurch gekennzeichnet,**

- **dass** man als Induktivität eine Anordnung aus einer ersten Spule (6) mit einer Windungszahl $N_1$ und eine zweite Spule (7) mit einer Windungszahl $N_2$ verwendet, wobei das Verhältnis gebildet aus der Windungszahl

$N_2$ und der Windungszahl $N_1$ gemäß der Beziehung $N_2/N_1 < 1$ gebildet wird, und
- **dass** die erste Spule (6) mit der zweiten Spule (7) mittels eines Magnetkerns (8, der einen Luftspalt aufweist, gekoppelt wird.

**4.** Verfahren nach Anspruch 3, **dadurch gekennzeichnet, dass** der Grad der Kopplung $\varepsilon$ zwischen der ersten Wicklung (6) und der zweiten Wicklung (7) durch die Beziehung

$$\varepsilon \neq [(n^2-1)/n^2] \text{ für alle } n\{3,5,7,9,...\}$$

vorgegeben wird.

**5.** Verfahren zum Umrüsten eines Transformators, an dessen Kern zumindest eine Kompensationsspule (3) angeordnet ist, welche mit einem Gleichstromerzeuger (1) verbunden ist um in die Kompensationsspule (3) einen Kompensationsstrom einzuspeisen, der einem Gleichfluss-Anteil im Kern des Transformators in seiner Wirkung entgegengerichtet ist, wobei eine Anordnung nach einem der Ansprüche 1 bis 2 verwendet wird, oder ein Verfahren nach einem der Ansprüche 3 oder 4 durchgeführt wird.

**Claims**

**1.** Arrangement for reducing a DC field component in the core of a transformer, comprising:

- a compensation winding (3) which is magnetically coupled to the core (4) of the transformer,
- a DC generator (1) which is arranged in series with the compensation winding (3) and with a reactance dipole (5), wherein the reactance dipole (5) is formed from a parallel circuit of an inductance and a capacitor, in order to feed into the compensation winding (3) a compensating current ($I_{GL}$), the effect of which is in the opposite direction to the DC field component in the core (4),
**characterised in that**

- the inductance is formed from a first winding (6) which is magnetically coupled to a second winding (7), wherein the ratio formed from the number of turns $N_2$ of the second winding (7) and the number of turns $N_1$ of the first winding (6) is formed according to the relationship $N_2/N_1 < 1$,
- the first winding (6) is connected by its one end to the DC generator (1) and by its other end to the compensation winding (3), and
- the second winding (7) is connected in parallel with the capacitor (C), and
- the magnetic coupling of the first winding (6) and of the second winding (7) is established by means of a soft magnetic core (8) which has an air gap.

**2.** Device according to claim 1, **characterised in that** the degree of coupling $\varepsilon$ between the first winding (6) and the second winding (7) is formed by the relationship

$$\varepsilon \neq [(n^2-1)/n^2] \text{ for all } n\{3,5,7,9,...\}$$

**3.** Method for reducing a DC field component in the core of a transformer, wherein a DC generator (1) feeds into a compensation winding (3) coupled to the core (4) of the transformer a compensating current ($I_{GL}$), the effect of which is in the opposite direction to the DC field component, wherein the compensating current ($I_{GL}$) is introduced into an electrical circuit (2) having a reactance dipole (5), wherein the reactance dipole (5) comprises an inductance and a capacitance, **characterised in that**

- an arrangement consisting of a first coil (6) having a number of turns $N_1$ and a second coil (7) having a number of turns $N_2$ is used as the inductance, wherein the ratio formed from the number of turns $N_2$ and the number of turns $N_1$ is formed according to the relationship $N_2/N_1 < 1$, and

- the first coil (6) is coupled to the second coil (7) by means of a magnet core (8) which has an air gap.

**4.** Method according to claim 3, **characterised in that** the degree of coupling $\varepsilon$ between the first winding (6) and the second winding (7) is given by the relationship

$$\varepsilon \neq [(n^2-1)/n^2] \text{ for all } n\{3,5,7,9,...\}$$

**5.** Method for modifying a transformer, on the core of which is arranged at least one compensation coil (3) which is connected to a DC generator (1) in order to feed into the compensation coil (3) a compensating current, the effect of which is in the opposite direction to a unidirectional flux component in the core of the transformer, wherein an arrangement according to one of claims 1 to 2 is used, or a method according to claim 3 or 4 is carried out.

**Revendications**

**1.** Dispositif destiné à diminuer une proportion de champ continu dans le noyau d'un transformateur, comprenant :

- une bobine de compensation (3), qui est couplée magnétiquement au noyau (4) du transformateur,
- un générateur de courant continu (1), qui est disposé en série avec la bobine de compensation (3) et avec un dipôle réactif (5), le dipôle réactif (5) étant formé par une commutation en parallèle d'une inductance et d'un condensateur, afin d'injecter un courant de compensation ($I_{GL}$) dans la bobine de compensation (3) dont l'action est opposée à la proportion de champ continu dans le noyau (4),
**caractérisé**
- **en ce que** l'inductance est formée par une première bobine (6) qui est couplée magnétiquement à une deuxième bobine (7), le rapport formé entre le nombre de spires $N_2$ de la deuxième bobine (7) et le nombre de spires $N_1$ de la première bobine (6) étant formé selon la relation $N_2/N_1 < 1$,
- **en ce que** la première bobine (6) est connectée en une extrémité au générateur de courant continu (1) et en l'autre extrémité à la bobine de compensation (3), et
- **en ce que** la deuxième bobine (7) est commutée en parallèle avec le condensateur (C), et
- **en ce que** le couplage magnétique de la première bobine (6) et de la deuxième bobine (7) est réalisé au moyen d'un noyau magnétique doux (8) qui présente une fente d'air.

**2.** Dispositif selon la revendication 1, **caractérisé en ce que** le degré de couplage $\varepsilon$ entre la première bobine (6) et la deuxième bobine (7) est formé par la relation

$$\varepsilon \neq [(n^2-1)/n^2] \text{ pour tous les } n \{3,5,7,9,...\}$$

**3.** Procédé pour diminuer une proportion de champ continu dans le noyau d'un transformateur, un générateur de courant continu (1) injectant un courant de compensation ($I_{GL}$) dans une bobine de compensation (3) couplée au noyau (4) du transformateur, dont l'action est opposée à la proportion de champ continu, le courant de compensation ($I_{GL}$) étant guidé dans un circuit électrique (2) avec un dipôle réactif (5), le dipôle réactif (5) présentant une inductance et une capacité, **caractérisé**

- **en ce qu'**on utilise comme inductance une disposition d'une première bobine (6) présentant un nombre de spires $N_1$ et d'une deuxième bobine (7) présentant un nombre de spires $N_2$, le rapport formé par le nombre de spires $N_2$ et le nombre de spires $N_1$ étant formé selon la relation $N_2/N_1 < 1$, et
- **en ce que** la première bobine (6) est couplée à la deuxième bobine (7) au moyen d'un noyau magnétique (8) qui présente une fente d'air.

**4.** Procédé selon la revendication 3, **caractérisé en ce que** le degré de couplage $\varepsilon$ entre la première bobine (6) et la deuxième bobine (7) est donné par la relation

$$\varepsilon \neq [\ (n^2-1)\ /n^2]\ \text{pour tous les n}\ \{3,5,7,9,...\}$$

5. Procédé pour rééquiper un transformateur, sur le noyau duquel est disposée au moins une bobine de compensation (3), qui est connectée à un générateur de courant continu (1) pour injecter un courant de compensation dans la bobine de compensation (3), dont l'action est opposée à une proportion de flux continu dans le noyau du transformateur, un dispositif selon l'une quelconque des revendications 1 à 2 étant utilisé ou un procédé selon l'une quelconque des revendications 3 ou 4 étant réalisé.

**EP 2 622 615 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008151661 A
- DE 634027 C